# EUROPEAN PATENT APPLICATION

(11) **EP 3 343 621 A1**
(43) Date of publication of application: **04.07.2018**
(21) Application number: 17205260.7
(22) Date of filing: 04.12.2017
(51) Int. Cl.: H01L 27/146, H01L 21/02, H01L 21/762

(54) **A METHOD FOR MANUFACTURING A SEMICONDUCTOR DEVICE**

(30) Priority: 28.12.2016 JP 2016256105
(71) Applicant: Renesas Electronics Corporation, Tokyo 135-0061 (JP)
(72) Inventor: YAMAGUCHI, Tadashi, Koutou-ku, Tokyo 135-0061 (JP)
(74) Representative: Moore, Graeme Patrick

(57) **Abstract**

The pixel characteristics are prevented from being degraded due to diffusion of electrons and Fe (iron) from the surface of an element isolation trench formed in the top surface of a semiconductor substrate into a photodiode forming the pixel of an image sensing element. Further, oxygen is prevented from being diffused from a boron oxide film formed at the surface of the element isolation trench into the photodiode. In the top surface of the semiconductor substrate, a trench for embedding an element isolation region surrounding a photodiode-forming region is formed. Then, B (boron) is doped into the surface of the trench to form a semiconductor layer. Subsequently, the boron oxide film resulting from the reaction between the boron deposited at the surface and oxygen is removed by APM washing. Then, a heat treatment is performed to diffuse the boron in the semiconductor layer.

## Description

### CROSS-REFERENCE TO RELATED APPLICATIONS

The disclosure of Japanese Patent Application No. 2016-256105 filed on December 28, 2016 including the specification, drawings and abstract is incorporated herein by reference in its entirety.

### BACKGROUND

The present invention relates to a method for manufacturing a semiconductor device, and more particularly, relates to a technology effectively applicable to manufacturing of a semiconductor device including an image sensing element.

An image sensing element (image element) for use in a digital camera or the like includes, for example, a plurality of pixels each including a photodiode for detecting a light and generating an electric charge arranged in a matrix. As is known, one pixel includes the photodiode, a transfer transistor for outputting the electric charge to a peripheral element, and the peripheral element for performing amplification of of a signal, and the like. The layout of the photodiode formed at the main surface of the semiconductor substrate is defined by element isolation regions surrounding the periphery of the photodiode. As the method for forming the element isolation region, the following method is known: a trench is formed in the main surface of the semiconductor substrate, and an insulation film is embedded in the trench, thereby to form an element isolation region formed of the insulation film.

Patent Document 1(Japanese Unexamined Patent Application Publication No. 2016-134614) describes as follows: an insulation film is embedded in the trench in the top surface of a semiconductor substrate, thereby to form an element isolation region; thus, electrons or Fe (iron) is diffused from the boundary between the element isolation region and the semiconductor substrate into the photodiode, unfavorably resulting in the degradation of the pixel characteristics. Under such circumstances, in Patent Document 1, B (boron) is uniformly doped at a given depth into the surface of the trench for element isolation by a plasma doping method. As a result, diffusion of electrons and iron is prevented.

### Cited document

### Patent Document

Patent Document 1 Japanese Unexamined Patent Application Publication No. 2016-134614

### SUMMARY

As in Patent Document 1, using a photoresist film as an ion implantation inhibiting mask, boron is doped into the surface of an element isolating trench . Then, the photoresist film is removed by ashing, so that a B_{X}O_{Y} (boron oxide) film is formed at the surface. Then, by a heat treatment or the like, oxide in the boron oxide film is diffused in the photodiode, unfavorably resulting in the deterioration of the pixel characteristics (image sensing characteristics).

Other objects and novel features will be apparent from the description of this specification and the accompanying drawings.

The outline of representative ones of the embodiments disclosed in the present application, will be described in brief as follows.

A method for manufacturing a semiconductor device of one embodiment includes: after successively performing the steps of: forming a trench for embedding an element isolation region surrounding a photodiode formation region in the top surface of a semiconductor substrate; doping B (boron) into the side surface and the bottom surface of the trench; and removing the photoresist film by ashing, and before forming the element isolation region, performing a step of performing APM washing.

In accordance with one embodiment disclosed in the present application, the reliability of a semiconductor device can be improved. Particularly, the pixel characteristics can be prevented from being degraded.

### BRIEF DESCRIPTION OF THE DRAWINGS

FIG. 1 is a cross sectional view for illustrating a manufacturing step of a semiconductor device of First Embodiment of the present invention;
FIG. 2 is a cross sectional view of the semiconductor device during a manufacturing step following FIG. 1;
FIG. 3 is a cross sectional view of a plasma doping device for use in a manufacturing step of the semiconductor device of First Embodiment of the present invention;
FIG. 4 is a cross sectional view of the semiconductor device during a manufacturing step following FIG. 2;
FIG. 5 is a cross sectional view of the semiconductor device during a manufacturing step following FIG. 4;
FIG. 6 is a cross sectional view of the semiconductor device during a manufacturing step following FIG. 5;
FIG. 7 is a cross sectional view of the semiconductor device during a manufacturing step following FIG. 6;
FIG. 8 is a cross sectional view of the semiconductor device during a manufacturing step following FIG. 7;
FIG. 9 is a cross sectional view of the semiconductor device during a manufacturing step following FIG. 8;
FIG. 10 is a cross sectional view of the semiconductor device during a manufacturing step following FIG. 9;
FIG. 11 is a cross sectional view of the semiconductor device during a manufacturing step following FIG. 10;
FIG. 12 is a cross sectional view of the semiconductor device during a manufacturing step following FIG. 11;
FIG. 13 is a cross sectional view of the semiconductor device during a manufacturing step following FIG. 12;
FIG. 14 is a cross sectional view of the semiconductor device during a manufacturing step following FIG. 13;
FIG. 15 is a cross sectional view of the semiconductor device during a manufacturing step following FIG. 14;
FIG. 16 is a cross sectional view of the semiconductor device during a manufacturing step following FIG. 15;
FIG. 17 is a cross sectional view of the semiconductor device during a manufacturing step following FIG. 16;
FIG. 18 is a cross sectional view of the semiconductor device during a manufacturing step following FIG. 17;
FIG. 19 is a cross sectional view of the semiconductor device during a manufacturing step following FIG. 18;
FIG. 20 is a cross sectional view of the semiconductor device during a manufacturing step following FIG. 19;
FIG. 21 is a cross sectional view of the semiconductor device during a manufacturing step following FIG. 20;
FIG. 22 is a cross sectional view of the semiconductor device during a manufacturing step following FIG. 21;
FIG. 23 is a cross sectional view of the semiconductor device during a manufacturing step following FIG. 22;
FIG. 24 is a plan view showing the layout of the semiconductor device of First Embodiment of the present invention;
FIG. 25 is an equivalent circuit diagram showing the semiconductor device of First Embodiment of the present invention;
FIG. 26 is a cross sectional view for illustrating a manufacturing step of a semiconductor device of Modified Example of First Embodiment of the present invention;
FIG. 27 is a cross sectional view of the semiconductor device during a manufacturing step following FIG. 26;
FIG. 28 is a cross sectional view for illustrating a manufacturing step of a semiconductor device of Second Embodiment of the present invention;
FIG. 29 is a cross sectional view for illustrating a manufacturing step of a semiconductor device of Third Embodiment of the present invention;
FIG. 30 is a cross sectional view of the semiconductor device during a manufacturing step following FIG. 29;
FIG. 31 is a cross sectional view of the semiconductor device during a manufacturing step following FIG. 30;
FIG. 32 is a cross sectional view of the semiconductor device during a manufacturing step following FIG. 31;
FIG. 33 is a cross sectional view of the semiconductor device during a manufacturing step following FIG. 32;
FIG. 34 is a cross sectional view of the semiconductor device during a manufacturing step following FIG. 33; and
FIG. 35 is a cross sectional view for illustrating a manufacturing step of a semiconductor device of Comparative Example.

### DETAILED DESCRIPTION

Below, embodiments of the present invention will be described in details by reference to the accompanying drawings. Incidentally, in all the drawings for describing the embodiments, the members having the same function are given the same reference signs and numerals, and a repeated description thereon is omitted. Further, in the following embodiments, unless otherwise required, a description on the same or similar portions will not be repeated in principle.

Whereas, reference signs "⁻" and "⁺" each represent the relative density of the impurity in a semiconductor having a conductivity type of N type or P type. For example, in the case of an N type impurity, the impurity density increases in the order of "N⁻", "N", and "N⁺". However, irrespective of the height of the impurity density like "N⁻", "N", and "N⁺", the conductivity types thereof may be generically referred to as N type. This also applies to a P type semiconductor.

### First Embodiment

A semiconductor device of the present embodiment relates to an image sensing element (solid-state image sensing element), and particularly relates to an image sensing element in which a photodiode forming a pixel is surrounded by element isolation regions having a STI (Shallow Trench Isolation) structure. The image sensing element is a CMOS (Complementary Metal Oxide Semiconductor) image sensor.

In the present embodiment, B (boron) is doped into the side surface and the bottom surface of a trench (element isolation trench) for embedding the element isolation region therein, thereby to prevent the degradation of the pixel characteristics caused by diffusion of electrons and Fe (iron) into the photodiode. In this case, the oxide film formed at the side surface and the bottom surface of the trench is removed by APM. Herein, a description will be given by assuming a four-transistor type pixel for use as a pixel realizing circuit in a CMOS image sensor as one example of the pixel. However, the present invention is not limited thereto.

### Regarding a method for manufacturing a semiconductor device

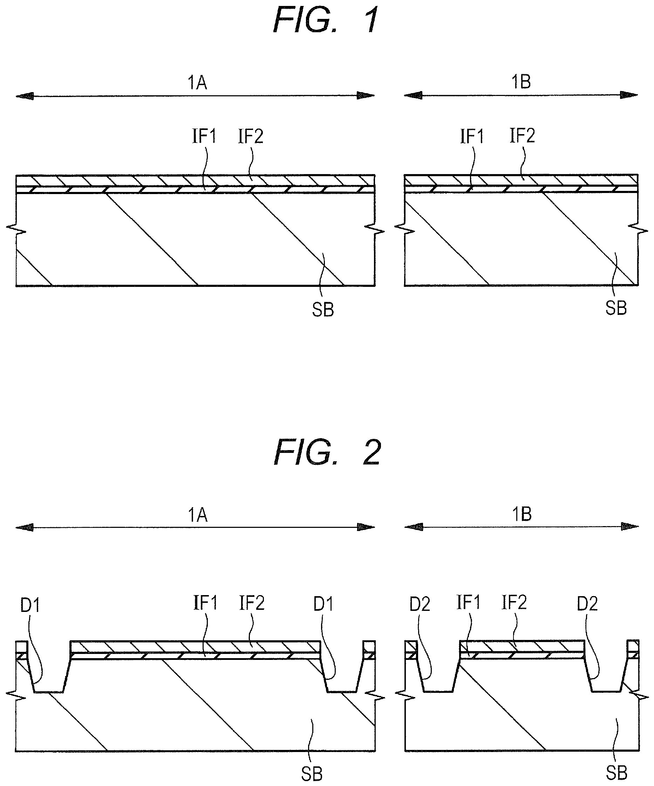

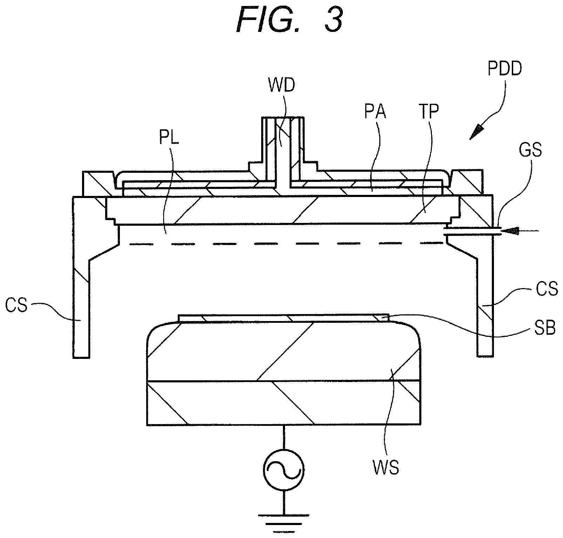

Below, by reference to FIGS. 1 to 23, a method for manufacturing a semiconductor device of the present embodiment will be described. FIGS. 1, 2, and 4 to 23 are each a cross sectional view for illustrating a manufacturing step of the semiconductor device of the present embodiment. FIG. 3 is a cross sectional view of a plasma doping device for use in the manufacturing steps of the semiconductor device of the present embodiment.

In FIGS. 1 to 23, the cross section in a pixel region 1A is shown on the left side of the drawing, and the cross section in a logic circuit region 1B is shown on the right side of the drawing. The pixel region 1A and the logic circuit region 1B are regions adjacent to each other in the direction along the main surface of the semiconductor substrate over the same semiconductor substrate. The pixel region 1A is a region forming a photodiode and its peripheral element. The logic circuit region 1B is a region forming a MOSFET (Metal Oxide Semiconductor Field Effect Transistor, MOS type field effect transistor) forming an analog / digital converting circuit, or the like. Herein, a description will be given to a step of forming an N type MOSFET in the logic circuit region 1B. However, a P type MOSFET is also formed in other regions not shown in the logic circuit region 1B. In other words, a CMOS is formed in the logic circuit region 1B.

First, as shown in FIG. 1, a semiconductor substrate SB is provided. The semiconductor substrate SB is formed of, for example, a P type single crystal silicon (Si). Subsequently, over the semiconductor substrate SB, an insulation film IF1 formed of a silicon oxide film is formed using, for example, a thermal oxidation method. Subsequently, using, for example, a CVD (Chemical Vapor Deposition) method, an insulation film IF2 formed of, for example, a silicon nitride film is formed over the insulation film IF1. As a result, the main surface of the semiconductor substrate SB is covered with a lamination film of the insulation films IF1 and IF2.

Then, as shown in FIG. 2, using a photolithography technology and an etching method, respective portions of the lamination films in the pixel region 1A and the logic circuit region 1B are removed. As a result, the main surface of the semiconductor substrate SB is partially exposed from the insulation films IF1 and IF2. Herein, the insulation films IF1 and IF2 over the semiconductor substrate SB in the active regions such as the region where a photodiode is formed in a later step, and a region where a MOSFET is formed in a later step are left, and the insulation films IF1 and IF2 in other regions (field regions) are removed.

Subsequently, using the insulation films IF1 and IF2 as a mask, trenches D1 and D2 are formed at the top surface of the semiconductor substrate SB using a dry etching method. In other words, using the insulation films IF1 and IF2 as a mask pattern, the trenches D1 and D2 are formed by anisotropic etching. The trench D1 is formed in the pixel region 1A, and the trench D2 is formed in the logic circuit region 1B. The trench D1 is formed annularly so as to surround the region where the photodiode is formed in a later step in a plan view. The trenches D1 and D2 both have the same formation depth. Respective bottom surfaces of the trenches D1 and D2 extend to the intermediate depth of the semiconductor substrate SB. Then, washing is performed using hydrofluoric acid (HF), thereby to remove the deposits such as etching residues.

The dry etching for forming the trenches D1 and D2 is anisotropic etching. By performing the etching, the surface of the semiconductor substrate SB exposed at respective insides of the trenches D1 and D2 is damaged. Further, by performing the etching, Fe (iron) is doped into the surface of the semiconductor substrate SB exposed at respective insides of the trenches D1 and D2. The iron is not intentionally doped into respective side surfaces and bottom surfaces of the trenches D1 and D2, but is doped into the exposed surface of the semiconductor substrate SB together with nickel (Ni), chromium (Cr), and the like when the trenches D1 and D2 are formed using a dry etching method. In other words, Fe contamination is caused at respective side surfaces and bottom surfaces of the trenches D1 and D2.

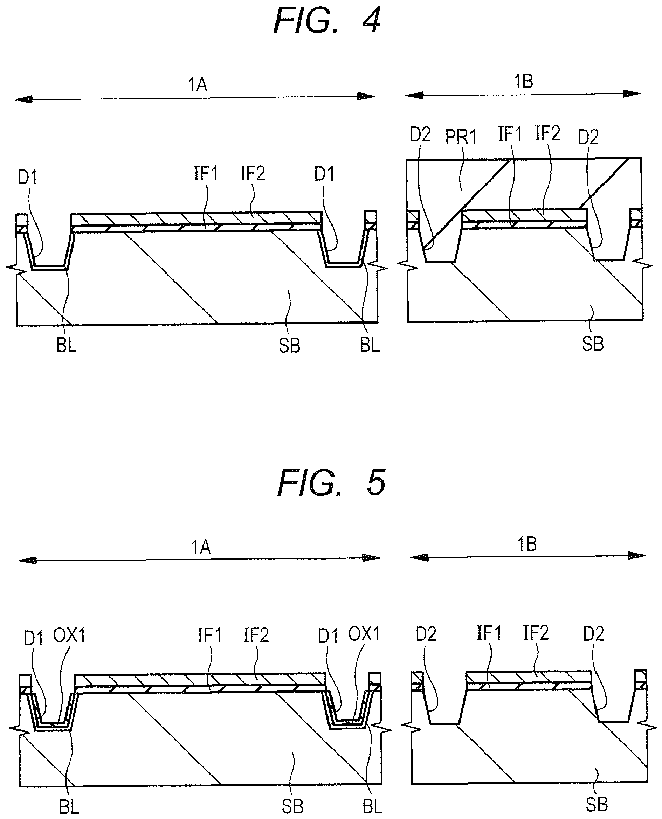

Then, the logic circuit region 1B is covered with a photoresist film PR1. Then, using a plasma doping device shown in FIG. 3 , B (boron) is doped into the exposed surface of the semiconductor substrate SB from the insulation films IF1 and IF2, namely, the side surface and the bottom surface of the trench D1 by a plasma doping method as shown in FIG. 4. In other words, with the logic circuit region 1B covered with the photoresist film PR1, and with the pixel region 1A exposed from the photoresist film PR1, plasma doping is performed. Herein, the semiconductor substrate SB in the logic circuit region 1B is covered with the photoresist film PR1, and hence boron is not doped into the side surface and the bottom surface of the trench D2.

Herein, with the semiconductor substrate SB in the logic circuit region 1B covered with the photoresist film PR1, plasma doping is performed, so that boron is not doped into the side surface and the bottom surface of the trench D2. This is for preventing the fluctuations in characteristics of a transistor to be formed later in the logic circuit region 1B. Namely, when boron is doped into the end of the active region of a transistor to be formed in the logic circuit region 1B, namely, for example, the end of the source / drain region, or the end of the channel region, the threshold voltage of the transistor varies. As a result, the circuit including the transistor may cease to operate normally. Accordingly, herein, boron is not doped into the side surface and the bottom surface of the trench D2 in the logic circuit region 1B.

As shown in FIG. 3, a plasma doping device PDD has a container CS forming a chamber, a wafer stage (mounting base) WS arranged in the container CS, a top sheet TP arranged above the wafer stage WS in the container CS, a planar antenna PA arranged over the top sheet TP, and a waveguide WD arranged over the planar antenna PA. The waveguide WD is coupled with a microwave generator (not shown) . A gas supply part GS for doping a plasma stabilizing gas, a doping gas, and the like into the container CS is provided at the side surface of the container CS at a height between the wafer stage WS and the top sheet TP. The gas in the container CS can be exhausted by a pump (not shown), so that the inside of the container CS can be set in a vacuum state.

Herein, for the surface of the semiconductor substrate (semiconductor wafer) SB of a to-be-processed object, a plasma doping method is used in which the impurity element (boron) contained in the doping gas is doped using a plasma. Specifically, first, the semiconductor substrate SB is mounted so as to be in contact with the top surface of the wafer stage WS. The pressure in the container CS is 50 to 150 mTorr, and is desirably set at 50 mTorr. The wafer stage WS can be applied with a biasing high frequency electric power (RF: RadioFrequency). However, in the present embodiment, RF biasing is not performed. In other words, the RF bias to the wafer stage WS is 0 W.

Then, a mixed gas of B₂H₆ (diborane) and He (helium) is supplied as a doping gas into the container CS from the gas supply part GS, so that a microwave with an output of 3 kW is supplied from the microwave generator via the waveguide WD to the planar antenna PA. Accordingly, a plasma PL is generated in a region at the top in the container CS, and under the top sheet TP, thereby to perform doping using a plasma. As a result, the impurity element (boron) in the doping gas is doped into the surface of the semiconductor substrate SB. Incidentally, herein, use of a B₂H₆ (diborane) gas as the doping gas will be described. However, as another doping gas, a BF₃ gas may be used.

By the plasma doping, as shown in FIG. 4, B (boron) is doped into the surface of the semiconductor substrate SB exposed from the insulation films IF1 and IF2, in other words, the side surface and the bottom surface of the trench D1, resulting in the formation of a semiconductor layer BL containing boron. The B (boron) contained in the doping gas and the semiconductor layer BL contains ¹⁰B and ¹¹B of the isotope of boron. The doping amount of boron of the semiconductor layer BL is 5 × 10¹³ to 2 × 10¹⁴ cm⁻², and the thickness of the semiconductor layer BL is, for example, 1 to 2 nm. The semiconductor layer BL is not formed at the surfaces of the logic circuit region 1B covered with the photoresist film PR1, and the semiconductor substrate SB covered with the insulation films IF1 and IF2.

The RF bias to the wafer stage WS of the plasma doping device PDD for use in the plasma doping is set at 0 W. This is for preventing B (boron) ions (radicals) in the plasma from being positively captured into the surface of the semiconductor substrate SB. This prevents the surface of the semiconductor substrate SB, in other words, the side surface and the bottom surface of the trench D1 from being damaged by plasma doping. Further, the RF bias is 0 W, and hence the thickness of the semiconductor layer BL is relatively smaller. The thickness of the semiconductor layer BL formed at the side surface of the trench D1 is thus suppressed. This can prevent the reduction of the light receiving area of the photodiode formed in the region surrounded by the trench D1.

Further, the pressure in the container CS in the plasma doping is set at 50 to 150 mTorr. This is for preventing the surface of the semiconductor substrate SB, in other words, the side surface and the bottom surface of the trench D1 from being damaged by too large pressure in the container CS. Accordingly, the pressure in the container CS is desirably as low as about 50 mTorr.

Then, as shown in FIG. 5, by performing ashing (an ashing treatment), the photoresist film PR1 is removed. Namely, in an ashing device (ashing chamber), the semiconductor substrate SB is set. Subsequently, O₂ (oxygen) is supplied into the ashing device. Subsequently, the oxygen in the ashing device is converted into a plasma by a high frequency. In other words, an O₂ plasma (oxygen in an active state) is generated. The O₂ plasma and the photoresist film PR1 formed of an organic matter are allowed to react with each other, so that the photoresist film PR1 is burnt and ashed. The ashed photoresist film PR1 finally becomes CO₂ (carbon dioxide) or H₂O (water) to be exhausted to outside the ashing device. As a result, the photoresist film PR1 covering the surface of the semiconductor substrate SB in the logic circuit region 1B is removed, so that the main surface of the semiconductor substrate SB is exposed.

In other words, herein, plasma ashing is performed to remove the photoresist film PR1. Incidentally, photoexcited ashing may be performed in an atmosphere of an O₃ (ozone) gas, thereby to remove the photoresist film PR1. The photoexcited ashing is the following method: a reactive gas such as an ozone gas is doped into a treatment chamber, and the photoresist over the substrate is ashed and removed while applying a light such as ultraviolet rays, and promoting the chemical reaction between the reactive gas and the photoresist.

In this step, the boron deposited at the surface of the trench D1 in the pixel region 1A in the plasma doping step described by reference to FIGS. 3 and 4 reacts with the oxygen in an active state in the ashing device. As a result, a boron oxide film OX1 is formed at the surface of the trench D1. In other words, an insulation film formed of B_{X}O_{Y} (boron oxide) covering the side surface and the bottom surface of the semiconductor layer BL is formed. The film thickness of the boron oxide film OX1 is, for example, 1 to 2 nm.

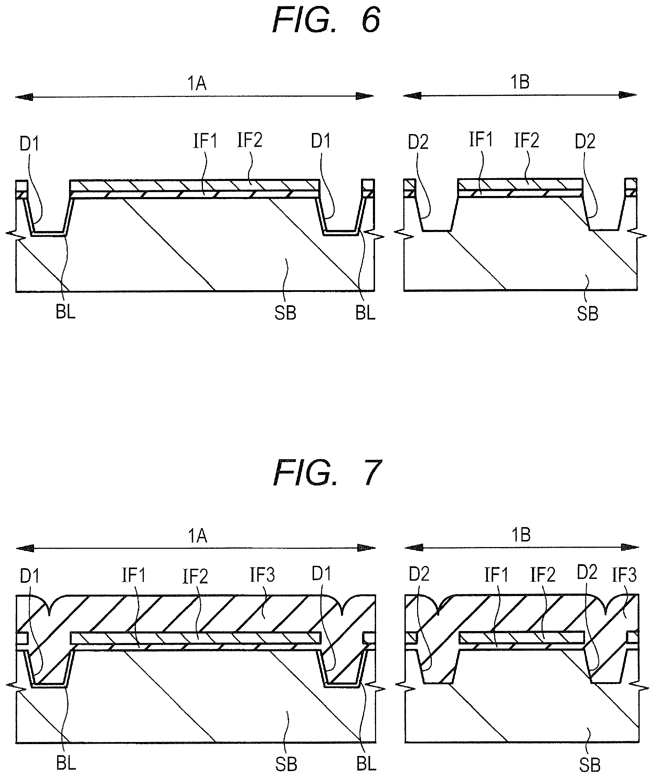

Then, as shown in FIG. 6, APM (Ammonium Hydrogen Peroxide Mixture) washing is performed, thereby to remove the boron oxide film OX1. As a result, the surface of the trench D1 is exposed. Herein, washing is performed using APM (Ammonium hydrogen Peroxide Mixture). The washing is performed under a temperature condition of, for example, 40 to 75°C. As a result, the boron oxide film OX1 is completely removed. Herein, when the temperature of APM washing is set excessively high, the surface of the semiconductor substrate SB is etched. Accordingly, the semiconductor layer BL formed by doping boron in the step described by reference to FIGS. 3 and 4 is removed. Therefore, in order to prevent the semiconductor layer BL from being removed, the temperature range of APM washing is more preferably set at 40 to 70°C.

Subsequently, as pre-washing, HPM (Hydrochloric acid hydrogen Peroxide Mixture) washing is performed. In other words, the semiconductor substrate SB is washed using HPM (Hydrochloric acid hydrogen Peroxide Mixture). The HPM washing is performed at room temperature. Herein, by performing the HPM washing, it is possible to remove the metal contamination at the surface of the semiconductor substrate SB.

Incidentally, SPM washing may be performed between the APM washing step and the HPM washing. Namely, washing may be performed using SPM (Sulfuric acid and hydrogen Peroxide Mixture), in other words, a mixed solution of sulfuric acid (H₂SO₄) and hydrogen peroxide (H₂O₂). The SPM washing is performed at a temperature of, for example, 120°C or less. Herein, by performing the SPM washing, it is possible to remove the photoresist film PR1 left without being fully removed even when the ashing step was performed.

Subsequently, 30-second RTA (rapid thermal annealing) is performed by a heat of 900 to 1100°C. By this heat treatment, the boron doped into the semiconductor layer BL is diffused. Herein, the heat treatment is performed by a heat of, for example, 900°C. The temperature of the heat treatment is set at 900 to 1100°C. This is for the following reason. When the temperature is too low, boron is not sufficiently diffused. Whereas, when the temperature is too high, excessive diffusion is caused. This unfavorably causes the reduction of the light receiving area of the photodiode to be formed later.

By plasma doping and the heat diffusion, the semiconductor layer BL is uniformly (conformally) formed to a given depth from respective surfaces of the side surface and the bottom surface of the trench D1. In other words, the boron contained in the semiconductor layer BL is doped with a density of 1 × 10¹⁷ cm³ or more in the range of 20 nm from the surface of the semiconductor substrate SB. In other words, the semiconductor layer BL in which the internal boron has been diffused by the heat treatment has a thickness of 20 nm or more from the surface of the semiconductor substrate SB. The formation depth from the surface of the semiconductor substrate SB, of the semiconductor layer BL in which the internal boron has been diffused by the heat treatment is deeper than that of the region in which iron has been doped into the side surface and the bottom surface of the trench D1 by the dry etching step described by reference to FIG. 2. Accordingly, as described later, the boron in the semiconductor layer BL can prevent the diffusion of iron into the active region in which a photodiode is formed.

The semiconductor layer BL having the boron density as described above is formed uniformly in such a manner as to surround the region (first region) in which a photodiode is formed later in a plan view. Incidentally, the region sandwiched between the two trenches D1 shown in the drawing includes a region in which a transfer transistor described later is formed, in addition to the photodiode forming region.

Then, as shown in FIG. 7, using a plasma CVD method or a low pressure heat CVD method, an insulation film IF3 formed of a silicon oxide film is formed entirely over the main surface of the semiconductor substrate SB. The insulation film IF3 is formed with a relatively larger film thickness, and is formed in such a manner as to fully fill respective trenches D1 and D2. Incidentally, before the formation of the insulation film IF3, respective side surfaces and bottom surfaces of the trenches D1 and D2 may be oxidized (oxidized at the inner wall), thereby to form a thin oxide film.

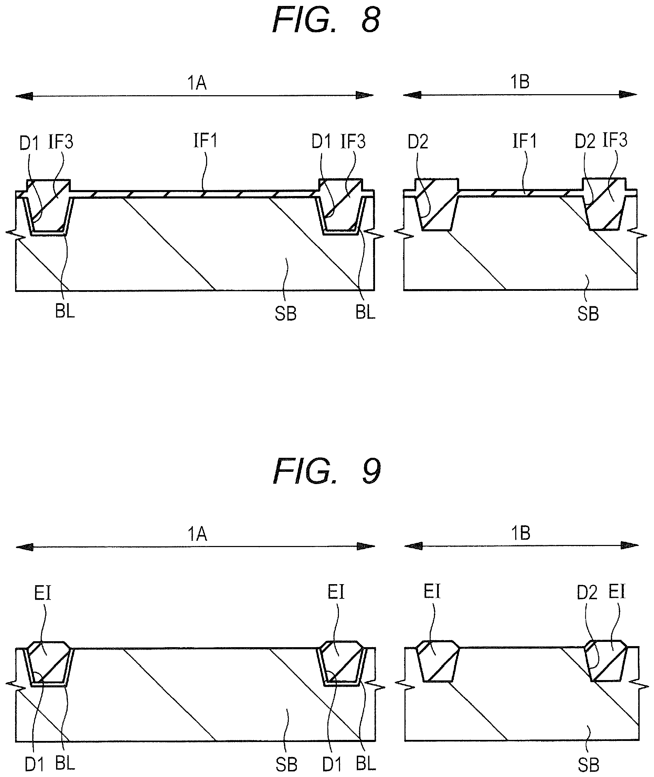

Then, as shown in FIG. 8, using a CMP (Chemical Mechanical Polishing) method, the top surface of the insulation film IF3 is polished, thereby to expose the insulation film IF2. Then, the insulation film IF2 is removed.

Then, as shown in FIG. 9, by performing wet etching using hydrofluoric acid (HF), the insulation film IF1 and a part of the insulation film IF3 are removed. As a result, a part of the main surface of the semiconductor substrate SB is exposed. However, respective insides of the trenches D1 and D2 have been still filled with the insulation film IF3 (see FIG. 8), so that respective side surfaces and bottom surfaces of the trenches D1 and D2 are not exposed. The insulation film IF3 left at respective insides of the trenches D1 and D2 by the etching forms an element isolation region EI. The element isolation region EI has a STI structure. Incidentally, in the present application, the region where the main surface of the semiconductor substrate SB is exposed from the element isolation region EI may be referred to as an active region.

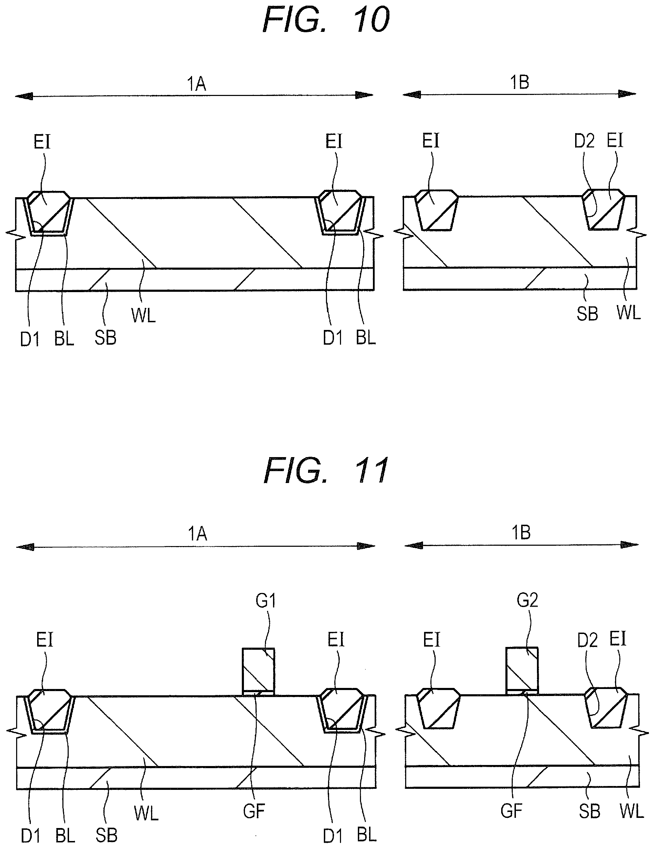

Then, as shown in FIG. 10, using a photolithography technology and an ion implantation method, a P type impurity (e.g., B (boron)) is implanted into the main surface of the semiconductor substrate SB, thereby to form a P type well WL. The well WL is a P⁻ type semiconductor region with a relatively lower impurity density. Herein, the well WL is formed in each portion of the main surface of the semiconductor substrate SB exposed respectively in the pixel region 1A and the logic circuit region 1B. The formation depth of the well WL is deeper than the formation depth of the element isolation region EI.

In the present embodiment, a description will be given to the case where an N type MOSFET is formed in the logic circuit region 1B. For this reason, herein, the P type well WL is also formed in the logic circuit region 1B. In contrast, although not shown, in the region which is the logic circuit region 1B, and where a P type MOSFET is formed, by a different ion implantation step from the ion implantation step of forming the well WL, the semiconductor substrate SB is doped with an N type impurity (e.g., P (phosphorous) or As (arsenic)), thereby to form an N type well.

Then, as shown in FIG. 11, a gate electrode G1 is formed over the semiconductor substrate SB in the pixel region 1A via a gate insulation film GF. A gate electrode G2 is formed over the semiconductor substrate SB in the logic circuit region 1B via the gate insulation film GF. Namely, over the semiconductor substrate SB, for example, by a thermal oxidation method, a silicon oxide film is formed, and over the silicon oxide film, a conductor film formed of, for example, polysilicon is formed. Then, using a photolithography technology and an etching method, the conductor film and the silicon oxide film are processed. This results in the formation of the gate insulation film GF formed of a silicon oxide film, and the gate electrodes G1 and G2 formed of the conductor film.

In the pixel region 1A, a lamination film formed of the gate insulation film GF and the gate electrode G1 is formed over the main surface of the semiconductor substrate SB exposed between the adjacent element isolation regions EI, and separated from the element isolation region EI. Similarly, in the logic circuit region 1B, a lamination film formed of the gate insulation film GF and the gate electrode G2 is formed over the main surface of the semiconductor substrate SB exposed between the adjacent element isolation regions EI, and separated from the element isolation region EI. However, in a region not shown, respective parts of the gate electrodes G1 and G2 are formed immediately on the element isolation region EI.

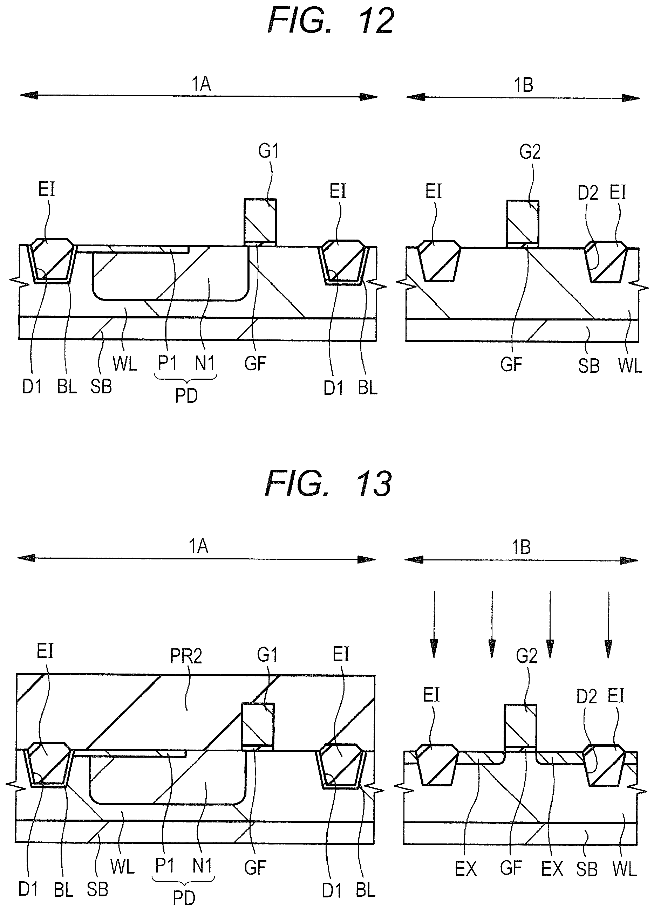

Then, as shown in FIG. 12, using a photolithography technology and an ion implantation method, at the top surface of the semiconductor substrate SB in the pixel region 1A, a photodiode PD including an N⁻ type semiconductor region N1 and a P⁺ type semiconductor region P1 is formed. The N⁻ type semiconductor region N1 is deeper in formation depth than the P⁺ type semiconductor region P1 and the element isolation region EI, and is shallower in formation depth than the well WL. The P⁺ type semiconductor region P1 is shallower in formation depth than the element isolation region EI. The photodiode PD is a photoelectric conversion element for generating signal electric charges in accordance with the light amount of the incident light.

Herein, an N type impurity (e.g., P (phosphorous) or arsenic (As)) is implanted into the main surface of the semiconductor substrate SB in the pixel region 1A by an ion implantation method, thereby to form an N⁻ type semiconductor region N1 in a region where a light receiving part is formed. Subsequently, a P type impurity (e.g., B (boron)) is implanted into the main surface of the semiconductor substrate SB in the pixel region 1A by an ion implantation method. As a result, a P⁺ type semiconductor region P1 is formed in a region where a light receiving part is formed. In other words, the N⁻ type semiconductor region N1 and the P⁺ type semiconductor region P1 are formed by different ion implantation steps using different photoresist films as masks.

As a result, at the main surface of the semiconductor substrate SB between the gate electrode G1 and the element isolation region EI, there is formed the photodiode PD formed of a PN junction part between the N⁻ type semiconductor region N1 and the P⁺ type semiconductor region P1. The gate electrode G1 is arranged in such a manner as to be sandwiched between the element isolation regions EI in a plan view. The photodiode PD is formed in the active region between one element isolation region EI lateral to the gate electrode G1 and the gate electrode G1. The photodiode PD is not formed in the active region between the other element isolation region EI lateral to the gate electrode G1 and the gate electrode G1.

Herein, the implantation by the ion implantation method is performed using a photoresist film (not shown) formed using a photolithography technology, and the gate electrode G1 as a mask. For this reason, impurity ions are not implanted into the logic circuit region 1B. In other words, the N⁻ type semiconductor region N1 and the P⁺ type semiconductor region P1 are not formed in the logic circuit region 1B. Further, the N⁻ type semiconductor region N1 is formed adjacent to the gate electrode G1. However, the P⁺ type semiconductor region P1 is formed at a position immediately over the N⁻ type semiconductor region N1, and separated from the gate electrode G1. Namely, the N⁻ type semiconductor region N1 is exposed at the main surface of the semiconductor substrate SB between the gate electrode G1 and the P⁺ type semiconductor region P1.

Then, as shown in FIG. 13, the pixel region 1A is covered with a photoresist film PR2. Then, with the photoresist film PR2 and the gate electrode G2 as a mask, a pair of extension regions EX are formed at the main surface of the semiconductor substrate SB in the logic circuit region 1B. Herein, an N type impurity (e.g., P (phosphorous) or arsenic (As)) is implanted with a relatively lower density using, for example, an ion implantation method into the main surface of the semiconductor substrate SB exposed in the logic circuit region 1B. As a result, the extension regions EX of a pair of N⁻ type semiconductor regions are formed in such a manner as to interpose the gate electrode G2 therebetween in a plan view.

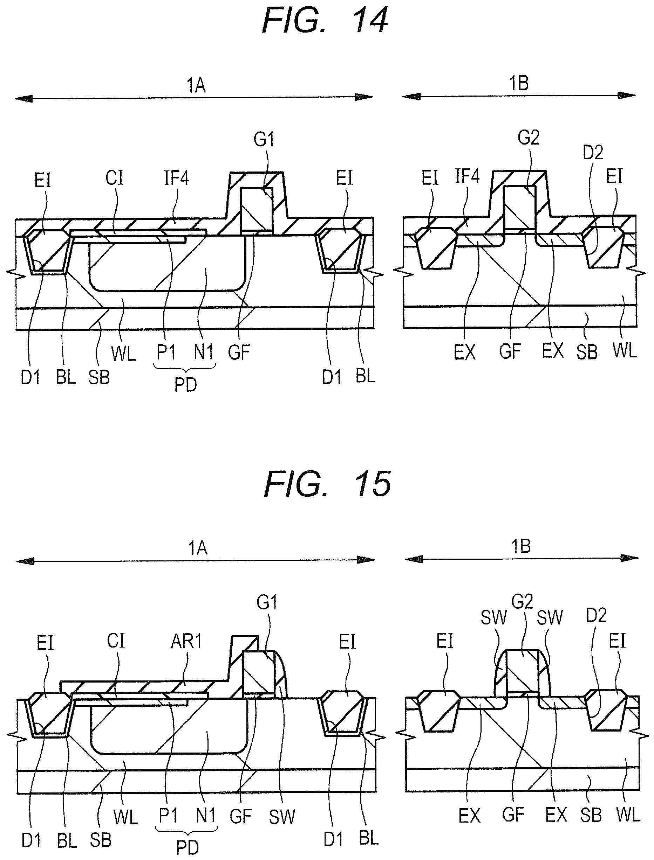

Then, as shown in FIG. 14, the photoresist film PR2 is removed. Then, a cap insulation film CI covering the top surface of the photodiode PD, and an insulation film IF4 covering the cap insulation film CI, the gate electrodes G1 and G2, the element isolation region EI, and the main surface of the semiconductor substrate SB are sequentially formed.

The cap insulation film CI is formed in the following manner: for example, using a CVD method, a silicon oxide film covering the entire main surface of the semiconductor substrate SB is formed; then, using a photolithography technology and an etching method, the silicon oxide film is processed. The cap insulation film CI is a film covering the top surface of the photodiode P, and does not cover other active regions . Herein, the formation of the cap insulation film CI using a CVD method was described. However, the following is also acceptable: the insulation film forming the gate insulation film GF in the pixel region 1A is left over the formation region of the photodiode PD; and the insulation film immediately over the photodiode PD is used as a cap insulation film.

The insulation film IF4 is formed of, for example, a silicon nitride film, and can be formed using, for example, a CVD method after the formation of the cap insulation film CI.

Then, as shown in FIG. 15, using a photolithography technology and a dry etching method, the insulation film IF4 is processed. Herein, etching is performed using a photoresist film (not shown) covering the photodiode PD, a part of the gate electrode G1 and a part of the element isolation region EI adjacent to the photodiode PD, and the gate electrodes G1 and G2 as a mask. Therefore, an antireflection film AR1 formed of the insulation film IF4 is left immediately over the photodiode PD between respective top surfaces of the gate electrode G1 and the element isolation region EI arranged in such a manner as to interpose the photodiode PD therebetween in a plan view.

Further, a sidewall SW formed of the insulation film IF4 is formed in a self-alignment manner in such a manner as to be in contact with the side surface opposite to the side surface in contact with the antireflection film AR1 of the side surfaces of the gate electrode G1. Further, a sidewall SW formed of the insulation film IF4 is formed in a self-alignment manner in such a manner as to be in contact with each side surface on the opposite sides of the gate electrode G2.

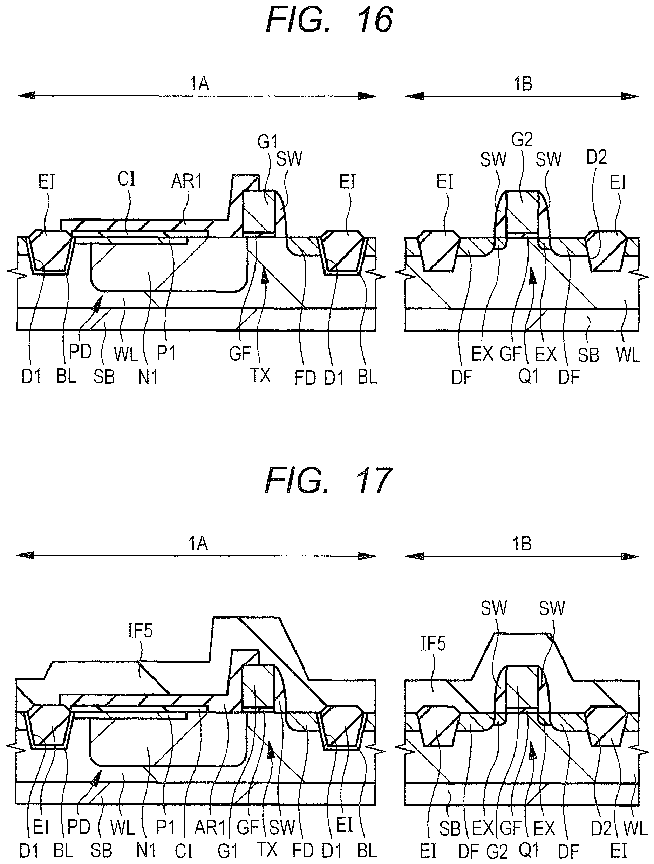

Then, as shown in FIG. 16, an N type impurity (e.g., P (phosphorous) or arsenic (As)) is implanted into the main surface of the semiconductor substrate SB using the gate electrodes G1 and G2, the antireflection film AR1, and the sidewalls SW as a mask with a relatively higher density, resulting in the formation of a floating diffusion capacitance part FD in the pixel region 1A, and a diffusion layer DF in the logic circuit region 1B. The floating diffusion capacitance part FD is an N⁺ type semiconductor region, and is formed at the main surface of the semiconductor substrate SB exposed from the antireflection film AR1 between the sidewall SW in contact with one side surface of the gate electrode G1 and the element isolation region EI. Whereas, a pair of diffusion layers DF each of an N⁺ type semiconductor region are formed at the main surface of the semiconductor substrate SB in such a manner as to interpose the gate electrode G2 and the sidewalls SW on the opposite sides thereof therebetween.

As a result, a transistor Q1 of a MOSFET including a pair of source / drain regions each formed of the diffusion layer DF and the extension region EX, and the gate electrode G2 is formed in the logic circuit region 1B. Whereas, a transfer transistor TX of a MOSFET having a pair of source / drain regions formed of the N⁻ type semiconductor region N1 and the floating diffusion capacitance part FD, respectively, and the gate electrode G1 is formed in the pixel region 1A.

Each of the pair of source / drain regions in the logic circuit region 1B has a LDD (Lightly Doped Drain) structure including the extension region EX with a relatively lower impurity density, and the diffusion layer DF with a relatively higher impurity density. The floating diffusion capacitance part FD and the diffusion layer DF have a deeper formation depth than that of the extension region EX.

In the transfer transistor TX, the N⁻ type semiconductor region N1 functions as the source region of the transfer transistor TX, and the floating diffusion capacitance part FD functions as the drain region of the transfer transistor TX. Incidentally, although not herein described, the drain region of the transfer transistor TX may include the extension region EX having a lower impurity density than that of the floating diffusion capacitance part FD in addition to the floating diffusion capacitance part FD.

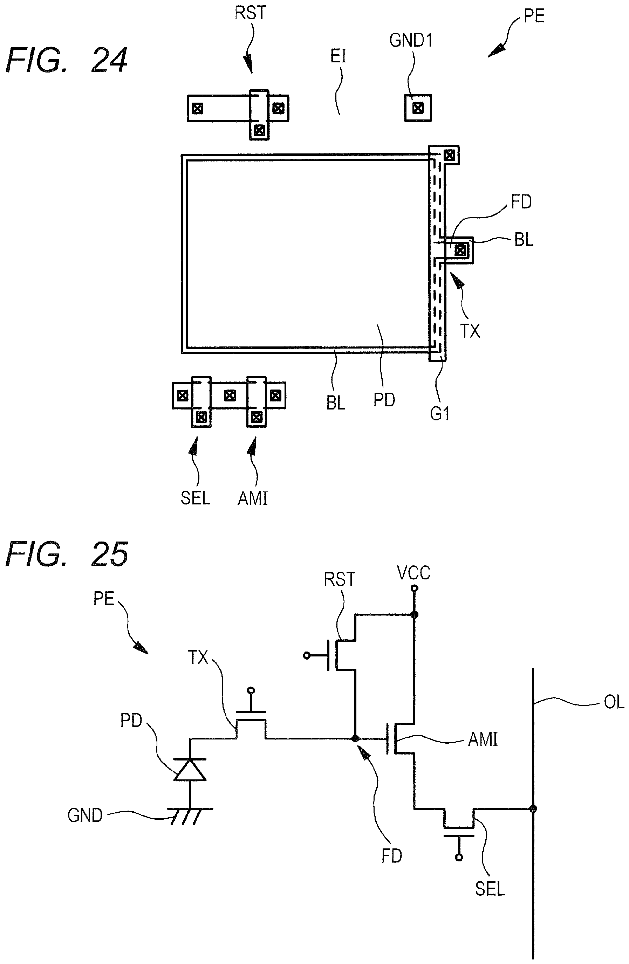

Further, by the foregoing steps, a reset transistor, an amplification transistor, and a selection transistor of peripheral transistors described later are formed in a region not shown. By the steps up to this point, a pixel PE (see FIG. 24) including the photodiode PD, the transfer transistor TX, and other peripheral transistors (not shown) is formed. Although not shown, a plurality of pixels PE are formed in a manner arranged in a matrix at the pixel array part over the semiconductor substrate SB. In other words, a plurality of photodiodes PD and their peripheral transistors are formed in a manner arranged in a matrix at the pixel array part.

Then, as shown in FIG. 17, for example, using a CVD method, an insulation film IF5 formed of a silicon oxide film is formed entirely over the main surface of the semiconductor substrate SB.

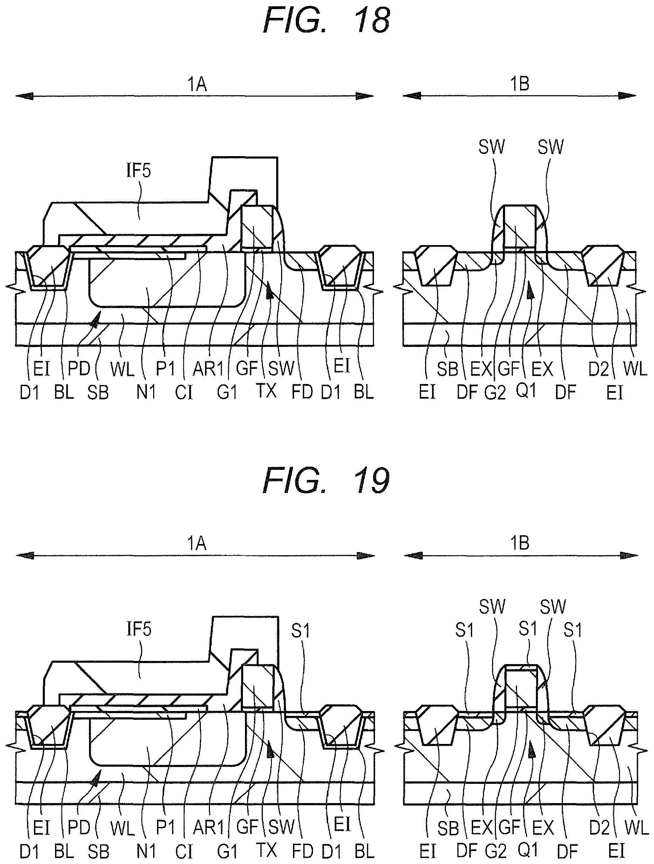

Then, as shown in FIG. 18, using a photolithography technology and a dry etching method, the insulation film IF5 is processed. As a result, the insulation film IF5 in the logic circuit region 1B is removed, so that the transistor Q1 is exposed from the insulation film IF5. Whereas, in the pixel region 1A, the top surface of the floating diffusion capacitance part FD is exposed from the insulation film IF5. Herein, the top surface of the gate electrode G1 has been still covered with the insulation film IF5. Whereas, the top surface of the photodiode PD is covered with the cap insulation film CI, the antireflection film AR1, and the insulation film IF5. The insulation film IF5 is used as a mask in a salicide process to be performed subsequently.

Then, as shown in FIG. 19, a salicide process is performed. As a result, a silicide layer S1 is formed over each of the top surface of the floating diffusion capacitance part FD, the top surface of the diffusion layer DF, and the top surface of the gate electrode G2. At this step, the silicide layer S1 is not formed at the top surface of the gate electrode G1 covered with the insulation film IF5. In the salicide process, first, using a sputtering method, a metal film containing, for example, Ni (nickel) is formed entirely over the main surface of the semiconductor substrate SB. Then, the semiconductor substrate SB is heated, so that the metal film and the semiconductor are allowed to react with each other, thereby forming the silicide layer S1. Then, the unreacted portions of the the metal film are removed.

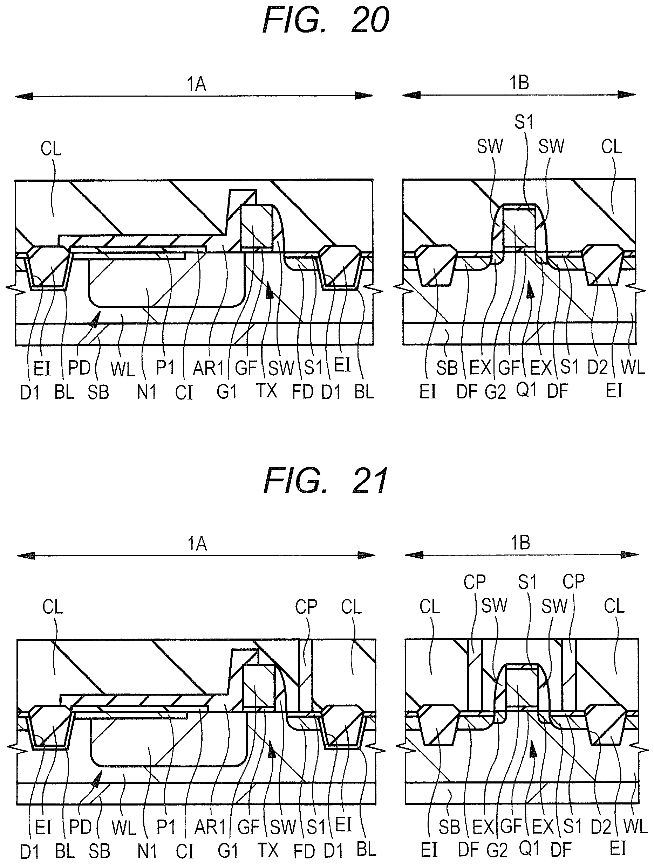

Then, as shown in FIG. 20, over the semiconductor substrate SB, an interlayer insulation film CL is formed. The interlayer insulation film CL is formed in the following manner: entirely over the main surface of the semiconductor substrate SB, for example, using a CVD method, a silicon oxide film is formed; and the top surface of the silicon oxide film is polished using a CMP method or the like. The film thickness of the interlayer insulation film CL is larger than the height of each top surface of the gate electrodes G1 and G2. Herein, the interlayer insulation film CL may be formed after removing the insulation film IF5. However, the insulation film IF5 and the interlayer insulation film CL may be integrated with each other by leaving the insulation film IF5, and forming the interlayer insulation film CL.

Then, as shown in FIG. 21, using a photolithography technology and a dry etching method, a plurality of contact holes penetrating through the interlayer insulation film CL are formed. Then, a plurality of contact plugs CP filling their respective contact holes are formed. Herein, a plurality of contact holes are formed so that the gate electrodes G1 and G2, the floating diffusion capacitance part FD, and the diffusion layer DF are exposed from the interlayer insulation film CL, respectively. At the bottom surface of each contact hole, the silicide layer S1 or the top surface of the gate electrode G1 is exposed. A contact hole is not formed immediately over the light receiving part including the photodiode PD. In the drawing, the contact plugs CP electrically coupled with the floating diffusion capacitance part FD and the diffusion layer DF are shown, and respective contact plugs CP over the gate electrodes G1 and G2 are not shown.

For the contact plugs CP, over the interlayer insulation film CL including the insides of a plurality of contact holes, a metal film mainly containing W (tungsten) is formed. Then, the metal film over the interlayer insulation film CL is removed by polishing with, for example, a CMP method, thereby to expose the top surface of the interlayer insulation film CL. This results in the formation of a plurality of contact plugs CP formed of the metal film respectively embedded in a plurality of contact holes . The contact plug CP is formed of, for example, a lamination film including a titanium nitride film covering the side surface and the bottom surface in the contact hole, and a tungsten film embedded in the contact hole via the titanium nitride film.

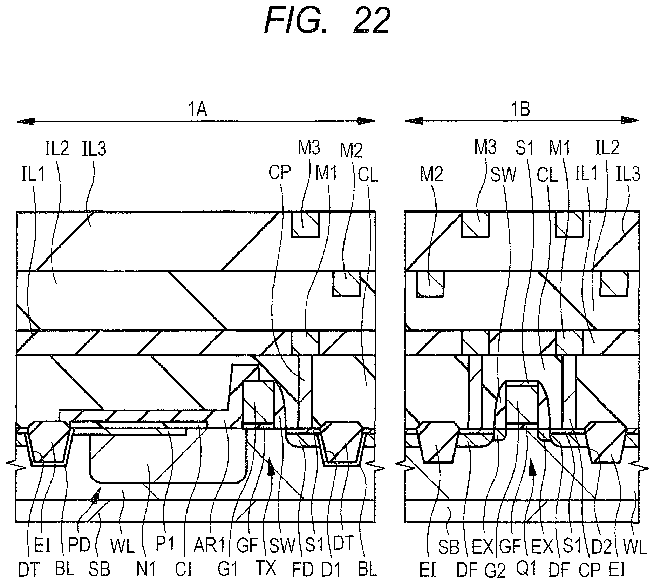

Then, as shown in FIG. 22, a first wiring layer, a second wiring layer, and a third wiring layer are stacked. The first wiring layer includes the interlayer insulation film IL1 and a wire M1, the second wiring layer includes the interlayer insulation film IL2 and a wire M2, and the third wiring layer includes the interlayer insulation film IL3 and a wire M3. The wire M1 of a lower-layer wire is formed by a so-called single damascene method, and the wires M2 and M3 of upper-layer wires are formed by a so-called dual damascene method. When the damascene methods are used, the wires M1 to M3 are formed of, for example, a Cu (copper) film. When, after forming a wire without using the damascene method, the lateral part of the wire is filled with an interlayer insulation film, the wires M1 to M3 are formed of, for example, an Al (aluminum) film.

Herein, a description will be given to the case using a damascene method. After obtaining the structure shown in FIG. 21, as shown in FIG. 22, over the interlayer insulation film CL, the interlayer insulation film IL1 formed of, for example, a silicon oxide film is formed, for example, using a CVD method. Then, the interlayer insulation film IL1 is processed using a photolithography technology and a dry etching method. This results in the formation of a wire trench which is an opening penetrating through the interlayer insulation film IL1, and which exposes the top surface of the interlayer insulation film CL and the top surface of the contact plug CP. Subsequently, a metal film is formed over the interlayer insulation film IL1 including the inside of the wire trench. The excess portions of the metal film over the interlayer insulation film IL1 are removed by a CMP method or the like, thereby to form the wire M1 formed of the metal film embedded in the wire trench.

The wire M1 has, for example, a lamination structure of a tantalum nitride film and a copper film sequentially stacked. The side surface and the bottom surface in the wire trench are covered with the tantalum nitride film. The wire M1 is coupled at the bottom surface thereof with the top surface of the contact plug CP.

Subsequently, over the interlayer insulation film IL1 and over the wire M1, vias (not shown), the wire M2, and the interlayer insulation film IL2 are formed. The dual damascene method herein used is the following method: for example, the interlayer insulation film IL2 is formed, and a via hole penetrating through the interlayer insulation film IL2 is formed; then, a wire trench shallower than the via hole is formed in the top surface of the interlayer insulation film IL2 immediately over the via hole; subsequently, a metal is embedded in the via hole and the wire trench, thereby to form the via in the via hole, and the wire M2 in the overlying wire trench at the same time. However, the following is also acceptable: after forming a wire trench, a via hole penetrating through the bottom surface of the wire trench to the bottom surface of the interlayer insulation film IL2 is provided; then, a via and the wire M2 are formed. The wire M1 is electrically coupled with the wire M2 via the via.

Then, in the same manner as with the second wiring layer, a third wiring layer including an interlayer insulation film IL3 over the interlayer insulation film IL2, vias (not shown), and a wire M3 is formed. The wire M3 is electrically coupled with the wire M1 via the via and the wire M2. Subsequently, an insulation film IF6 covering the top surface of the third wiring layer is formed. The insulation film IF6 is formed by, for example, a CVD method, and is formed of, for example, a silicon oxide film.

The wires M1 to M3 are formed in the pixel region 1A and the logic circuit region 1B. However, in the pixel region 1A, the wires M1 to M3 are not arranged immediately over the photodiode PD. This is for preventing the wires M1 to M3 from blocking a light incident from above the photodiode PD.

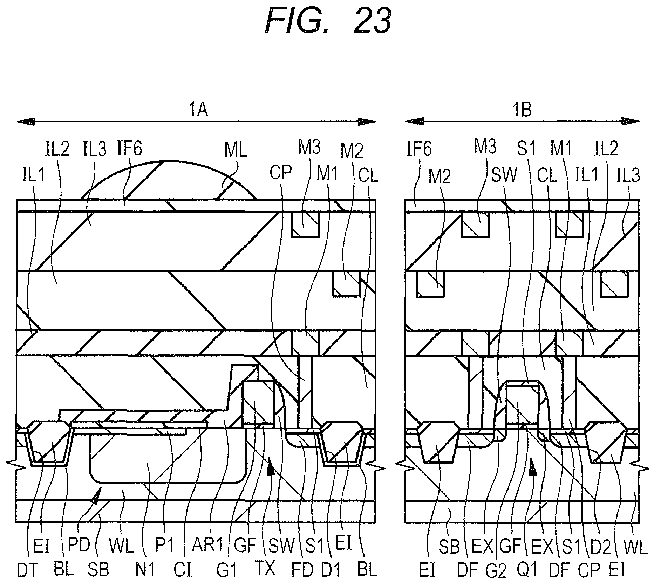

Then, as shown in FIG. 23, a microlens ML is formed over the insulation film IF6 in the pixel region 1A. Incidentally, a color filter may be formed between the interlayer insulation film IL3 and the microlens ML. The microlens ML is formed immediately over the photodiode PD. The microlens ML is formed in the following manner: the film formed over the insulation film IF6 is processed into a circular pattern in a plan view; then, for example, the film is heated, thereby to round the surface of the film; as a result, the film is processed into a lens shape.

In the subsequent steps, the semiconductor substrate SB, in other words, the scribe line of the semiconductor wafer is cut by dicing. As a result, the semiconductor wafer is singulated into a plurality of sensor chips, thereby to form a plurality of image sensing elements each formed of the sensor chip. This results in the completion of the semiconductor device of the present embodiment including the image sensing element.

Incidentally, herein, a description has been given to doping of boron into the surface of the trench D1 (see FIG. 4) shown in FIG. 4 using a plasma doping method. However, as the method for forming the semiconductor layer BL, not a plasma doping method but an ion implantation method may be used. However, as compared with the method for implanting boron into the trench D1 by an ion implantation method, use of a plasma doping method can provide the effect of being capable of preventing damaging of the surface of the trench D1, and the effect of facilitating uniform implantation of boron into the side surface and the bottom surface of the trench D1.

### Regarding structure and operation of image sensing element of semiconductor device

Below, the structure and the operation of the image sensing element of the semiconductor device of the present embodiment will be described by reference to FIGS. 24 and 25. FIG. 24 is a plan view showing the layout of the semiconductor device of the present embodiment. FIG. 25 is an equivalent circuit diagram showing the semiconductor device of the present embodiment. The image sensing element of the semiconductor device of the present embodiment is a CMOS image sensor including one semiconductor chip. In the pixel array part of the image sensing element, a plurality of pixels are formed. Namely, in the pixel array part, a plurality of pixels are arrayed and arranged in a matrix. In FIG. 24, the outline of the active region at the site covered with each gate electrode, and the outline of the semiconductor layer BL of the boron implantation region are indicated with a broken line.

As shown in FIG. 24, one pixel PE has the photodiode PD and a plurality of peripheral transistors. The periphery of the photodiode PD is surrounded by the element isolation region EI. The photodiode PD has a rectangular shape in a plan view. However, the active region where the photodiode PD is formed has a portion protruding at a part thereof from one side of the rectangular shape in a plan view, and a transfer transistor TX is formed in the vicinity of the protruding portion.

The transfer transistor TX has a floating diffusion capacitance part FD formed at the protruding portion, and an N⁻ type semiconductor region formed at the rectangular shape portion, and forming the photodiode PD as source / drain regions, and has a gate electrode G1 formed between the source / drain regions in a plan view. A semiconductor layer BL doped with boron is formed annularly with a uniform impurity density at the periphery of the active region where the source / drain regions and the photodiode PD are formed. In other words, the semiconductor layer BL is formed at the surface of the semiconductor substrate adjacent to the element isolation region EI, namely, the end of the active region including the photodiode PD in a plan view, and is formed continuously in such a manner as to go around the periphery of the active region.

Further, in one pixel PE, in the region adjacent to the photodiode PD, a grounding region GND1, a reset transistor RST, an amplification transistor AMI, and a selection transistor SEL of peripheral transistors are formed. Herein, the photodiode PD and the transfer transistor TX, the reset transistor RST, the amplification transistor AMI and the selection transistor SEL, and the grounding region GND1 are formed in separate active regions respectively divided by the element isolation regions EI. The amplification transistor AMI and the selection transistor SEL are formed in the same active region, and have one of mutual source / drain regions in common in the active region. The peripheral transistors are formed in the pixel region. However, the semiconductor layer BL containing boron is not formed in the active region including each peripheral transistor formed therein.

Then, FIG. 25 shows a circuit of one pixel. Each of the plurality of pixels has the circuit shown in FIG. 25. As shown in FIG. 25, the pixel has the photodiode PD for performing photoelectric conversion, and the transfer transistor TX for transferring electric charges generated at the photodiode. Further, the pixel has the floating diffusion capacitance part FD for accumulating the electric charges transferred from the transfer transistor TX, and the amplification transistor AMI for amplifying the electric potential of the floating diffusion capacitance part FD. The pixel further includes the selection transistor SEL for selecting whether the electric potential amplified by the amplification transistor AMI is outputted to the output line OL coupled with a read circuit (not shown), or not, and the reset transistor RST for initializing the electric potential of the cathode of the photodiode PD and the floating diffusion capacitance part FD to a prescribed electric potential.

Each of the transfer transistor TX, the reset transistor RST, the amplification transistor AMI, and the selection transistor SEL is, for example, an N type MOSFET.

The anode of the photodiode PD is applied with a grounding electric potential GND of a minus-side power supply potential, and the cathode of the photodiode PD is coupled with the source of the transfer transistor TX. The floating diffusion capacitance part FD is coupled with the drain of the transfer transistor TX, the source of the reset transistor RST, and the gate of the amplification transistor AMI. The drain of the reset transistor RST, and the drain of the amplification transistor AMI are applied with a plus-side power supply potential VCC. The source of the amplification transistor AMI is coupled with the drain of the selection transistor SEL. The source of the selection transistor SEL is coupled with the output line OL.

Then, the operation of the pixel will be described. First, the gate electrodes of the transfer transistor TX and the reset transistor RST are applied with a prescribed electric potential. Thus, the transfer transistor TX and the reset transistor RST are both rendered in an ON state. Then, the electric charges left at the photodiode PD, and the electric charges accumulated in the floating diffusion capacitance part FD flow toward the plus-side power supply potential VCC. As a result, the electric charges at the photodiode PD and the floating diffusion capacitance part FD are initialized. Subsequently, the reset transistor RST is rendered in an OFF state.

Then, an incident light is applied to the PN junction of the photodiode PD, so that photoelectric conversion is caused at the photodiode PD. As a result, electric charges are generated at the photodiode PD. The electric charges are all transferred by the transfer transistor TX to the floating diffusion capacitance part FD. The floating diffusion capacitance part FD accumulates the transferred electric charges. This results in a change in electric potential of the floating diffusion capacitance part FD.

Then, when the selection transistor SEL is rendered in an ON state, the electric potential of the floating diffusion capacitance part FD after change is amplified by the amplification transistor AMI, and then, is outputted to the output line OL. Then, the read circuit reads the electric potential of the output line OL. In this manner, electric charge information can be read from each of the plurality of pixels formed at the pixel array part, thereby to obtain an image imaged by the image sensing element.

### Regarding the effects of the present embodiment

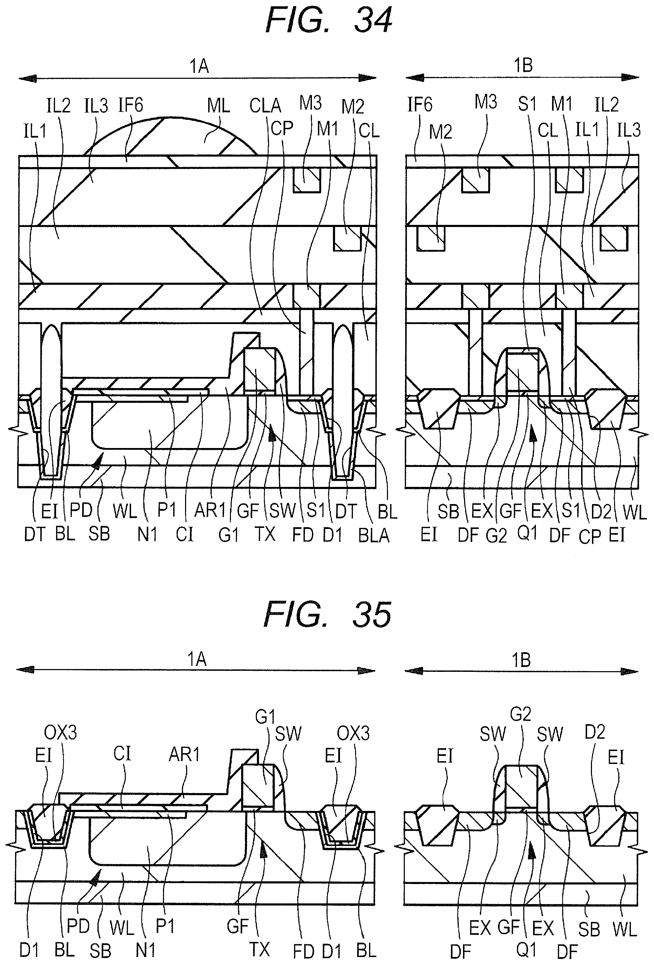

Below, the effects of the semiconductor device of the present embodiment will be described by reference to Comparative Example shown in FIG. 35. FIG. 35 is a cross sectional view for illustrating a manufacturing step of a semiconductor device in Comparative Example. Incidentally, FIG. 35 shows the pixel region 1A and the logic circuit region 1B as with FIG. 16.

For the image sensing element, in order to implement a higher speed of the CMOS in the logic circuit region to be mounted in a semiconductor chip, the element isolation region for defining a MOSFET and a photodiode is formed by a STI method. The element isolation region formed by the STI method is more largely damaged at the boundary between the semiconductor substrate and the element isolation region than the element isolation region formed by LOCOS (Local Oxidization of Silicon). This unfavorably facilitates generation of electrons at the boundary.

Namely, when the formation is achieved by embedding an insulation film in the trench formed in the semiconductor substrate, the side surface and the bottom surface of the trench are damaged by dry etching upon forming the trench by a dry etching method. At the interface between the element isolation region of a STI structure in which the insulation film is embedded in the trench thus formed and the semiconductor substrate, electrons are generated due to the damage. Diffusion of the electrons into the photodiode causes a white flaw defect during darkness (white point defect during darkness) in the pixel, resulting in degradation of the pixel characteristics.

In other words, diffusion of the electrons in the photodiode causes more electrons than the electrons generated by the photoelectric conversion to be collected in the photodiode. For this reason, the electric charges read in the pixel increase. In this case, in the pixel which has undergone the electron diffusion of the image information read from the image sensing element, the image becomes whitened. In other words, electrons are also generated in the pixel not applied with a light, and hence correct pixel information cannot be acquired. The phenomenon that correct image information thus becomes unable to be read is herein referred to as white flaw defect during darkness (white point defect during darkness).

Further, in the dry etching step for forming the trench for embedding the element isolation region, Fe (iron) is mixed in the side surface and the bottom surface of the the trench. The diffusion of the iron into the photodiode also causes the white flaw defect during darkness.

In contrast, B (boron) is doped into the semiconductor substrate in the vicinity of the boundary between the element isolation region and the semiconductor substrate. This can prevent the occurrence of the problem. When boron is doped into the semiconductor substrate in the vicinity of the boundary, the electrons generated in the boundary portion cannot exceed the potential barrier of the boron-doped semiconductor layer. This can prevent the diffusion of electrons in the photodiode. Further, the holes in the boron-doped semiconductor layer cancel electrons, which can prevent the diffusion of the electrons in the photodiode. Still further, boron traps the iron in the semiconductor substrate by gettering, which can prevent the diffusion of iron in the photodiode. Accordingly, the doping of boron can prevent the diffusion of electrons and iron. This can prevent the degradation of the pixel characteristics.

Thus, in the present embodiment, by the steps described by reference to FIGS. 3 and 4, boron is doped into the surface of the trench D1. As a result, the boron-containing semiconductor layer BL is formed. However, when the photoresist film PR1 used as a mask for preventing the doping of boron into the surface of the semiconductor substrate SB in the logic circuit region 1B is removed by an ashing method after the formation of the semiconductor layer BL, as described by reference to FIG. 5, oxygen and the boron in the semiconductor layer BL react with each other. As a result, an oxide film formed of boron oxide is formed in such a manner as to cover the surface of the trench D1.

The structure in which the photodiode PD, the transfer transistor TX, and the transistor Q1 are formed without removing the oxide film is shown as Comparative Example in FIG. 35. Namely, as shown in FIG. 35, the side surface and the bottom surface of the trench D1 are covered with a boron oxide film OX3 formed when the photoresist film PR1 is removed by an ashing method. The element isolation region EI is formed in the trench D1 via the boron oxide film OX3. The boron oxide film OX3 is the film formed resulting from the reaction between boron deposited at the surface of the trench D1 upon performing the step of doping boron into the surface of the trench D1 as described above and oxygen in the ashing step performed for removing the photoresist film PR1 (see FIG. 4).

In order to diffuse the boron doped into the surface of the trench D1 by a plasma doping method or the like, after the formation of the boron oxide film OX3 including B_{X}O_{Y}, and before the formation of the element isolation region EI, a heat treatment (drive-in annealing) at about 900°C is performed. As a result, the oxygen forming the boron oxide film OX3 is diffused into the semiconductor substrate SB. As a result, the dissolved oxygen (O) dissolved in the semiconductor substrate SB becomes a crystal defect or a grow-in defect in the silicon crystal forming the semiconductor substrate SB. The grow-in defect denotes the formation of a silicon oxide film in the semiconductor substrate SB. For the image sensing element mounted at the semiconductor substrate SB in which dissolved oxygen is thus dissolved, or the respective defects are formed, the pixel characteristics (image sensing characteristics) are undesirably degraded.

Incidentally, it can be considered that in the process of removing the photoresist film PR1, SPM washing is performed under the temperature condition of 70°C or less, or HPM washing is performed at room temperature. However, even when SPM washing or HPM washing is performed under such conditions, the boron oxide film OX3 cannot be sufficiently removed.

In contrast, in the present embodiment, as shown in FIG. 4, boron is doped into the surface of the trench D1, thereby to form the semiconductor layer BL. Subsequently, the photoresist film PR1 is removed by an ashing method. The boron oxide film OX1 (see FIG. 5) formed at this step is removed by performing APM washing as shown in FIG. 6. Therefore, even when a heat treatment at about 900°C is performed subsequently in order to diffuse the boron in the semiconductor layer BL, oxygen can be prevented from being dissolved into the semiconductor substrate SB from the surface of the trench D1, and the formation of a crystal defect and a grow-in defect can be prevented. Accordingly, it is possible to improve the reliability of the semiconductor device.

Further, APM washing is a washing method which is more likely to wash away silicon than SPM washing. When APM washing is performed at a high temperature of, for example, higher than 75°C, the surface of the trench D1 is washed away, so that the semiconductor layer BL formed at the surface of the trench D1 may be removed. In this case, undesirably, it becomes impossible to obtain the effect of preventing the diffusion of electrons or iron into the photodiode by doping of boron into the surface of the trench D1.

Thus, in the present embodiment, the temperature of APM washing is suppressed. Specifically, the temperature of the semiconductor substrate SB during APM washing is set at 40 to 75°C, or less. Further, from the viewpoint of preventing the surface of the trench D1 from being washed away, the temperature of the semiconductor substrate SB during APM washing is more preferably 40 to 70°C or less.

From the description up to this point, in the present embodiment, doping of boron into the surface of the semiconductor substrate SB adjacent to the element isolation region EI shown in FIG. 23 can prevent the degradation of the pixel characteristics due to the shrinkage of the light receiving area of the photodiode PD, and can prevent the formation of a white flaw defect during darkness due to the diffusion of electrons and iron. Further, in the present embodiment, it is possible to prevent oxygen from being dissolved into the semiconductor substrate SB from the boron oxide film OX1 (see FIG. 5) resulting from removal of the photoresist film PR1 (see FIG. 4) by an ashing method. This can prevent the formation of a crystal defect and a grow-in defect. Accordingly, it is possible to improve the reliability of the semiconductor device.

Further, in the present embodiment, boron is doped into the semiconductor substrate SB using plasma doping. For this reason, boron can be uniformly (conformally) doped into the surface of the semiconductor substrate SB exposed from the insulation films IF1 and IF2 (see FIG. 4). Therefore, it is possible to prevent ununiform doping of boron into the side surface and the bottom surface of the trench D1, and diffusion of electrons and iron into the photodiode from the site with a particularly low amount of boron implanted.

Further, in the present embodiment, as shown in FIG. 24, the boron-doped semiconductor layer BL is formed annularly with an uniform density at the periphery of the active region including the photodiode PD formed therein. For this reason, it is possible to prevent the diffusion of electrons and iron from some site of the periphery of the active region into the photodiode PD. Accordingly, it is possible to prevent the formation of a white flaw defect during darkness in the pixel. For this reason, it is possible to improve the reliability of the semiconductor device including an image sensing element.

### Modified Example

The configuration of the present Modified Example is also applicable to a back surface irradiation type image sensing element in which the photodiode is irradiated with a light from the back surface side of the semiconductor substrate.

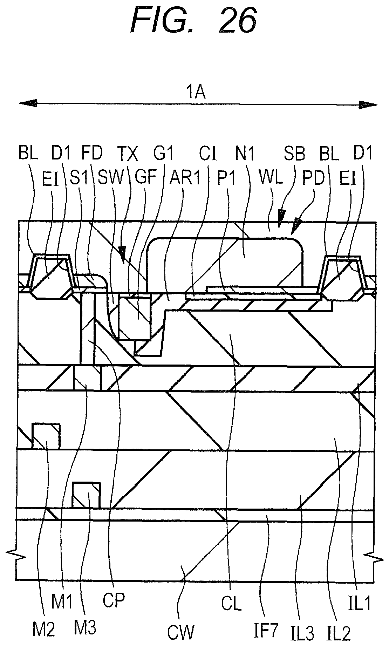

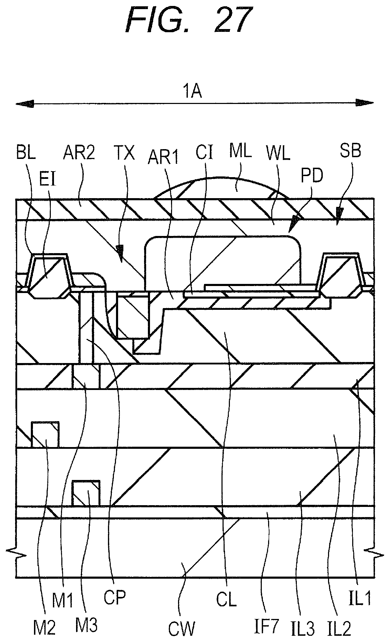

Below, a description will be given to doping of boron into the semiconductor substrate adjacent to the element isolation region by plasma doping in a back surface irradiation type image sensing element by reference to FIG. 26 and 27. However, the steps up to the step of forming a plurality of wiring layers are performed in the same manner as the steps described above. For this reason, specific manufacturing method up to the formation of the wiring layer will not be described. FIGS. 26 and 27 are each a cross sectional view for illustrating a manufacturing step of the semiconductor device of the present Modified Example. In FIGS. 26 and 27, the cross section in the pixel region 1A is shown, and the logic circuit region 1B (see FIG. 22) is not shown. However, the semiconductor device of the present Modified Example includes the logic circuit region 1B. By performing the steps described by reference to FIGS. 1 to 22, for example, a transistor is formed in the logic circuit region 1B.

First, by performing the steps described by reference to FIGS. 1 to 22, over the semiconductor substrate, the interlayer insulation film, the photodiode, the transfer transistor, the amplification transistor, the selection transistor, the reset transistor, the transistors in the logic circuit region, and a plurality of wiring layers are formed. Herein, the surface of the semiconductor substrate adjacent to the interlayer insulation film is doped with boron by a plasma doping step as described by reference to FIGS. 3 and 4. However, herein, the insulation film IF6 (see FIG. 23) is not formed.

Then, as shown in FIG. 26, the semiconductor substrate SB is turned upside down. However, below, the vertical direction, and the main surface and the back surface of the semiconductor substrate SB, and the like will be described in the same manner as with FIGS. 1, 2, and 4 to 22. Accordingly, the lower side of the semiconductor substrate SB in FIGS. 26 and 27 will be described as the main surface (the top surface) side of the semiconductor substrate SB, and the upper side of the semiconductor substrate SB will be described as the back surface (lower surface) side of the semiconductor substrate SB. In other words, for example, in FIGS. 26 and 27, the lower surface of the interlayer insulation film IL1 is in contact with the top surface of the interlayer insulation film CL, and the top surface of the interlayer insulation film IL1 is in contact with the lower surface of the interlayer insulation film IL2.

Subsequently, the top surface of the interlayer insulation film IL3 and the top surface of the wire M3 are bonded to the lower surface of a support substrate CW via an insulation film IF7 for adhesion. The support substrate CW is a silicon substrate provided separately from the semiconductor substrate SB. The insulation film IF7 includes a silicon oxide film formed in such a manner as to cover the back surface of the support substrate CW before the bonding step.

Subsequently, the back surface of the semiconductor substrate SB is polished, thereby to reduce the film thickness of the semiconductor substrate SB. Herein, polishing is performed until the film thickness from the main surface to the back surface of the semiconductor substrate SB becomes about 2 to 5 µm.

Then, as shown in FIG. 27, an antireflection film AR2 is formed in such a manner as to cover the back surface of the semiconductor substrate SB. The antireflection film AR2 includes, for example, a silicon nitride film, and is formed by, for example, a CVD method. Subsequently, a microlens ML covering the lower surface of the antireflection film AR2 is formed immediately under the photodiode PD. In other words, the microlens ML is formed at the back surface of the semiconductor substrate SB via the antireflection film AR2.

In the subsequent step, the semiconductor substrate SB, in other words, the scribe line of the semiconductor wafer is cut by dicing. As a result, the semiconductor wafer is singulated into a plurality of sensor chips, thereby to form a plurality of back surface irradiation type image sensing elements each formed of the sensor chip. This results in the completion of the semiconductor device of the present Modified Example including the image sensing element. The semiconductor device of the present Modified Example can provide the same effects as those of the method for manufacturing a semiconductor device described by reference to FIGS. 1 to 23.

### Second Embodiment

In the First Embodiment, a description has been given to the following: the boron oxide film formed in the ashing step after doping boron into the surface of the element isolation trench is removed by APM washing. However, the boron oxide film may be removed without performing the ashing step, and by performing SPM washing at high temperatures in place of APM washing.

In the present embodiment, first, the same steps as the steps described by reference to FIGS. 1 to 4 are performed, thereby to form a semiconductor layer BL at the surface of the trench D1.

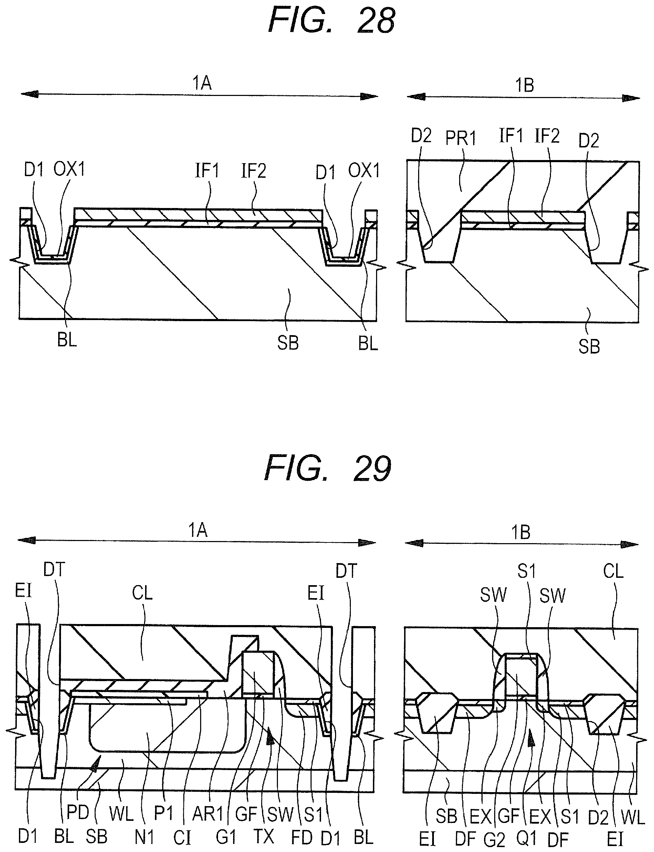

Then, as shown in FIG. 28, the semiconductor substrate SB is transported to outside the plasma doping device. At this step, the semiconductor substrate SB is exposed to the air (an oxygen-containing atmosphere, or an oxygen atmosphere) . Herein, O₂ (oxygen) in the air and the boron deposited at the surface of the trench D1 in the pixel region 1A in the plasma doping step react with each other. As a result, a boron oxide film OX1 is formed at the surface of the trench D1. In other words, the boron oxide film OX1 of the present embodiment is a natural oxide film.

Then, SPM washing is performed under a temperature condition of 160 to 230°C, thereby to remove the photoresist film PR1 (see FIG. 4) and the boron oxide film OX1. This provides the structure shown in FIG. 6. Incidentally, in order to remove foreign matters, after the SPM washing, APM washing may be performed at room temperature.

Namely, in the present embodiment, without performing ashing for removing the photoresist film PR1, the photoresist film PR1 is removed by high-temperature SPM washing. Even without performing ashing, when the semiconductor substrate SB is exposed to the air after the formation step of the semiconductor layer BL described by reference to FIGS. 3 and 4, as described above, the boron oxide film OX1 is formed as a natural oxide film.

SPM washing is a washing method not capable of removing the boron oxide film OX1 sufficiently even when performed, for example, under a temperature condition of about 70°C. However, herein, SPM washing is performed under a high temperature condition of 160 to 230°C, and hence can remove the boron oxide film OX1.

Subsequently, HPM washing is performed, thereby to remove the metal contamination at the surface of the semiconductor substrate SB. Subsequently, for example, a heat treatment (drive-in annealing) at 900°C for 30 seconds is performed, thereby to diffuse the boron in the semiconductor layer BL into the semiconductor substrate SB. The subsequent steps are performed in the same manner as with the steps described by reference to FIGS. 7 to 23, resulting in the completion of the semiconductor device of the present embodiment.

In the present embodiment, high-temperature SPM washing is performed. As a result, the boron oxide film OX1 can be removed. This can provide the same effects as those of the First Embodiment.

### Third Embodiment

The First Embodiment is also applicable to the case where DTI (Deep Trench Isolation) of a deeper element isolation structure than the element isolation region is formed. Below, by reference to FIGS. 29 to 34, the manufacturing steps of a semiconductor device of the present embodiment will be described. FIGS. 29 to 34 are each a cross sectional view for illustrating a manufacturing step of the semiconductor device of the present embodiment.

In the present embodiment, first, the same steps as the steps described by reference to FIGS. 1 to 20 are performed.

Then, as shown in FIG. 29, using a photolithography technology and a dry etching method, a deep trench DT extending from the top surface of the interlayer insulation film CL to the intermediate depth of the semiconductor substrate SB is formed in the pixel region 1A. In other words, herein, the trench DT is formed in the main surface of the semiconductor substrate SB immediately under the element isolation region EI. The trench DT penetrates through the interlayer insulation film CL, the element isolation region EI, and the semiconductor layer BL. At this step, the trench DT may also be formed in the logic circuit region 1B.

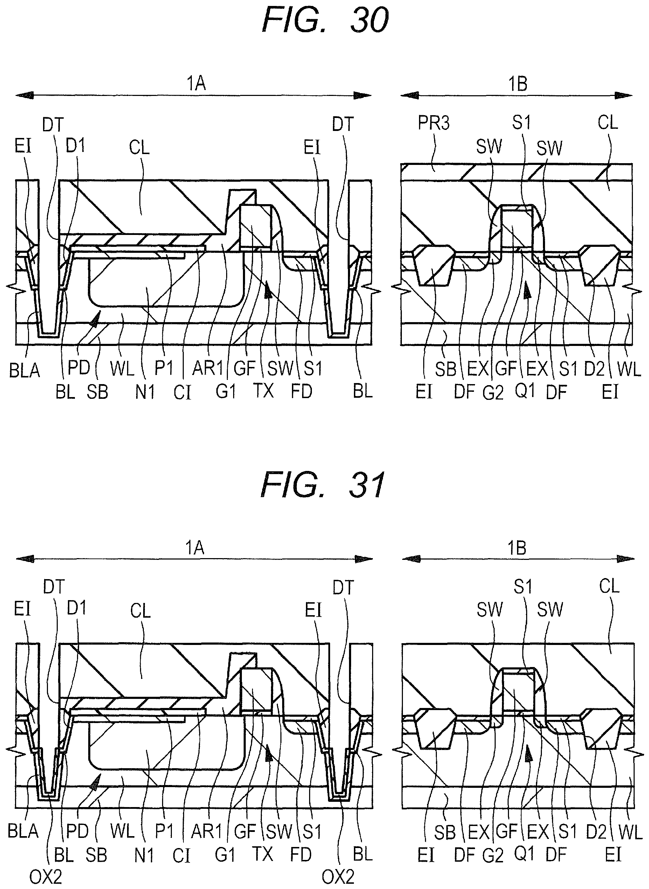

Then, as shown in FIG. 30, in the same manner as the steps described by reference to FIGS. 3 and 4, the logic circuit region IBis covered with a photoresist film PR3. Then, by using a plasma doping method, B (boron) is doped into the surface of the semiconductor substrate SB exposed in the trench DT. As a result, a semiconductor layer BLA is formed. Herein, in the logic circuit region 1B, in order to prevent boron from being doped into a site of the semiconductor substrate SB in which the trench DT (not shown) is formed, the photoresist film PR3 is formed. The semiconductor layer BLA is a semiconductor region obtained by doping the semiconductor substrate SB with boron. The thickness of the semiconductor layer BLA is, for example, 1 to 2 nm.

Then, as shown in FIG. 31, ashing (an ashing treatment) is performed, thereby to remove the photoresist film PR3. At this step, the O₂ plasma for use in the ashing step, and the boron particles deposited at the surface of the trench DT, and the like react with each other. This results in the formation of a boron oxide film OX2 covering the surface of the semiconductor substrate SB exposed in the trench DT. The boron oxide film OX2 includes B_{X}O_{Y}, and has a thickness of, for example, 1 to 2 nm.

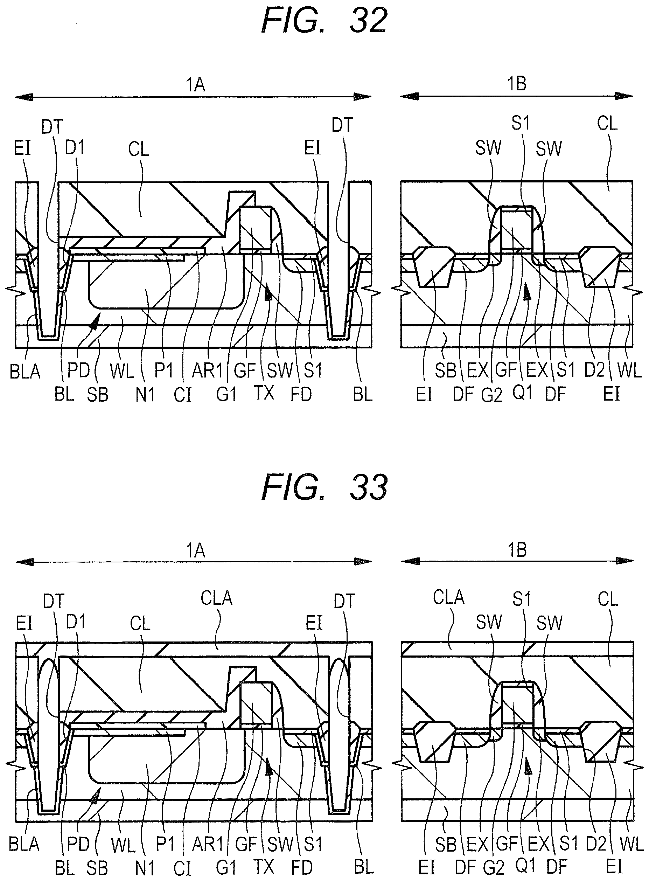

Then, as shown in FIG. 32, the same step as the step described by reference to FIG. 6 is performed. In other words, APM washing is performed under the temperature condition of, for example, 40 to 75°C, thereby to remove the boron oxide film OX2. As a result, the surface of the semiconductor substrate SB in the trench DT is exposed. Then, HPM washing is performed at room temperature, thereby to remove metal contamination. SPM washing may be performed at 120°C or less between the APM washing step and the HPM washing step, thereby to remove the residue of the photoresist film PR3 (see FIG. 30). Subsequently, for example, a 900°C heat treatment is performed for, for example, 30 seconds, thereby to diffuse the boron in the semiconductor layer BLA into the semiconductor substrate SB.

Then, as shown in FIG. 33, an insulation film (e.g., silicon oxide film) with a high viscosity and a low embedding property is deposited by a CVD method or the like over the interlayer insulation film CL. This result in the formation of an interlayer insulation film CLA blocking the top of the trench DT, and covering the top surface of the interlayer insulation film CL. In other words, the interlayer insulation film CLA covering the trench DT is formed over the main surface of the semiconductor substrate SB. As a result, the top of the trench DT is blocked by the interlayer insulation film CLA, so that a void is formed in the trench DT. The void is a region with a high insulation property. For this reason, the formation of the void can electrically isolate the adjacent elements. Incidentally, a part of the interlayer insulation film CLA may be formed in the trench DT. Alternatively, the following is also acceptable: the entire inside of the trench DT is filled with the interlayer insulation film CLA, and the void is not formed.

Then, as shown in FIG. 34, the same steps as the steps described by reference to FIGS. 21 to 23 are performed. As a result, the semiconductor device of the present embodiment is completed. Incidentally, when the step described by reference to FIG. 21 is performed, a contact plug CP penetrating through the lamination film including the interlayer insulation films CL and CLA is formed.

In the present embodiment, in order to enhance the effect of the element isolation, DTI formed of the trench DT deeper than the element isolation region EI is formed. Herein, DTI includes the trench DT, and the void in the trench DT. Herein, in the surface of the semiconductor substrate SB which is the surface of the trench DT, and is exposed in the trench DT under the element isolation region EI, the semiconductor layer BLA doped with boron is formed. This can prevent the degradation of the pixel characteristics due to the diffusion of oxygen or iron from the surface into the photodiode PD.

Further, in the step described by reference to FIG. 31, removal of the photoresist film PR3 (see FIG. 30) by ashing results in the formation of the boron oxide film OX2 covering the surface of the bottom of the trench DT. In contrast, in the present embodiment, by the step described by reference to FIG. 32, APM washing is performed, thereby to remove the boron oxide film OX2. Accordingly, even when a heat treatment at, for example, 900°C is performed in order to diffuse the boron in the semiconductor layer BLA into the semiconductor substrate SB after removal of the photoresist film PR3, oxygen will not be dissolved from the boron oxide film OX2 into the semiconductor substrate SB. Therefore, it is possible to prevent the degradation of the pixel characteristics due to dissolution of the oxygen. Accordingly, it is possible to improve the reliability of the semiconductor device.

Up to this point, the invention completed by the present inventors was specifically described by way of embodiments. However, it is naturally understood that the present invention is not limited to the embodiments, and may be variously changed within the scope not departing from the gist thereof.

For example, in the Third Embodiment in which DTI is formed, the following is also acceptable: as in the Second Embodiment, the photoresist film is removed by SPM washing without performing ashing; further, the boron oxide film OX2 (see FIG. 31) is removed by the SPM washing. Alternatively, the semiconductor device of the Second Embodiment or the Third Embodiment may be a back surface irradiation type image sensing element as with Modified Example of the First Embodiment.

Further, in the Third Embodiment, a description has been given to the removal of the boron oxide film OX2 (see FIG. 31) by performing APM washing. However, the following is also acceptable: as with the Second Embodiment, before removal of the photoresist film PR3, the semiconductor substrate SB is exposed to the air, thereby to form the boron oxide film OX2; then, not by APM washing but by SPM washing at 160°C or more, the boron oxide film OX2 and the photoresist film PR3 are removed.

## Claims

1. A method for manufacturing a semiconductor device including an image sensing element having a photoelectric conversion element for generating a signal electric charge according to the light amount of an incident light, the method comprising the steps of:
(a) providing a semiconductor substrate;
(b) forming a first trench surrounding a first region of a main surface of the semiconductor substrate in the main surface of the semiconductor substrate;
(c) covering a second region of the main surface of the semiconductor substrate with a first photoresist film, doping boron into the surface of the first trench using the first photoresist film as a mask, and thereby forming a first semiconductor layer containing boron in the surface of the first trench;
(d) removing the first photoresist film by an ashing treatment using oxygen, thereby allowing oxygen and boron in the surface of the first trench to react with each other, and thereby forming a first boron oxide film covering the surface of the first trench;
(e) performing APM washing, and thereby removing the first boron oxide film;
(f) after the step (e), embedding an insulation film in the first trench, and thereby forming an element isolation region including the insulation film; and
(g) forming the the photoelectric conversion element in the main surface of the semiconductor substrate in the first region.

2. The method for manufacturing a semiconductor device according to claim 1,
wherein, in the step (c), using the first photoresist film as a mask, plasma doping is performed, thereby to dope boron into the surface of the first trench, and thereby to form the first semiconductor layer.

3. The method for manufacturing a semiconductor device according to claim 1,
wherein in the step (b), the first trench, and a second trench adjacent to the second region of the main surface of the semiconductor substrate are formed,
wherein, in the step (c), with the second region and the second trench covered with the first photoresist film, the first semiconductor layer is formed at the surface of the first trench, and
wherein, in the step (f), the insulation film is embedded in each inside of the first trench and the second trench, thereby to form the element isolation region including the insulation film,
the method further comprising a step of:
(h) forming a field effect transistor over the semiconductor substrate in the second region.

4. The method for manufacturing a semiconductor device according to claim 1, further comprising a step of:
(e1) after the step (e), subjecting the semiconductor substrate to a heat treatment at 900 to 1100°C, and thereby diffusing boron in the first semiconductor layer.

5. The method for manufacturing a semiconductor device according to claim 1,
wherein in the step (e), the APM washing is performed under a temperature condition of 40 to 75°C, thereby to remove the first boron oxide film.

6. The method for manufacturing a semiconductor device according to claim 1, further comprising the steps of:
(i) after the step (g), forming a third trench deeper than the first trench in the main surface of the semiconductor substrate,
(j) covering the second region of the main surface of the semiconductor substrate with a second photoresist film, and doping boron into the surface of the third trench using the second photoresist film as a mask, and thereby forming a second semiconductor layer containing boron in the surface of the third trench,
(k) removing the second photoresist film by an ashing treatment using oxygen, and thereby allowing oxygen and boron in the surface of the third trench to react with each other, and thereby forming a second boron oxide film covering the surface of the third trench,
(l) performing APM washing, and thereby removing the second boron oxide film, and
(m) after the step (1), forming an interlayer insulation film over the semiconductor substrate, and thereby covering the third trench with the interlayer insulation film.

7. A method for manufacturing a semiconductor device including an image sensing element having a photoelectric conversion element for generating a signal electric charge according to the light amount of an incident light, the method comprising the steps of:
(a) providing a semiconductor substrate;
(b) forming a first trench surrounding a first region of a main surface of the semiconductor substrate in the main surface of the semiconductor substrate;
(c) covering a second region of the main surface of the semiconductor substrate with a first photoresist film, doping boron into the surface of the first trench using the first photoresist film as a mask, and thereby forming a first semiconductor layer containing boron in the surface of the first trench;
(d) exposing the semiconductor substrate to an oxygen atmosphere, and thereby allowing oxygen and boron in the surface of the first trench to react with each other, and thereby forming a first boron oxide film covering the surface of the first trench,
(e) performing SPM washing under a temperature condition of 160 to 230°C, and thereby removing the first photoresist film and the first boron oxide film,
(f) after the step (e), embedding an insulation film in the first trench, and thereby forming an element isolation region including the insulation film, and
(g) forming the photoelectric conversion element in the main surface of the semiconductor substrate in the first region.

8. The method for manufacturing a semiconductor device according to claim 7,
wherein, in the step (c), using the first photoresist film as a mask, plasma doping is performed, thereby to dope boron into the surface of the first trench, and thereby to form the first semiconductor layer.

9. The method for manufacturing a semiconductor device according to claim 7,
wherein in the step (b), the first trench, and a second trench adjacent to the second region of the main surface of the semiconductor substrate are formed,
wherein, in the step (c), with the second region and the second trench covered with the first photoresist film, the first semiconductor layer is formed at the surface of the first trench, and
wherein, in the step (f), the insulation film is embedded in each inside of the first trench and the second trench, thereby to form the element isolation region including the insulation film,
the method further comprising a step of:
(h) forming a field effect transistor over the semiconductor substrate in the second region.

10. The method for manufacturing a semiconductor device according to claim 7, further comprising a step of:
(e1) after the step (e), subjecting the semiconductor substrate to a heat treatment at 900 to 1100°C, and thereby diffusing boron in the first semiconductor layer.

11. The method for manufacturing a semiconductor device according to claim 7, further comprising the steps of:
(i) after the step (g), forming a third trench deeper than the first trench in the main surface of the semiconductor substrate,
(j) covering the second region of the main surface of the semiconductor substrate with a second photoresist film, and doping boron into the surface of the third trench using the second photoresist film as a mask, and thereby forming a second semiconductor layer containing boron at the surface of the third trench,
(k) removing the second photoresist film by an ashing treatment using oxygen, and thereby allowing oxygen and boron in the surface of the third trench to react with each other, and thereby forming a second boron oxide film covering the surface of the third trench,
(1) performing APM washing, and thereby removing the second boron oxide film, and
(m) after the step (1), forming an interlayer insulation film over the semiconductor substrate, and thereby covering the third trench with the interlayer insulation film.
